# FASCICULE DE BREVET EUROPEEN

(11) **EP 0 990 266 B1**
(45) Date de publication et mention de la délivrance du brevet: **11.09.2002**
(21) Numéro de dépôt: 98929532.4
(22) Date de dépôt: 10.06.1998
(51) Int. Cl.: H01L 21/331, H01L 29/732

(54) **TRANSISTOR HYPERFREQUENCE A STRUCTURE QUASI-AUTOALIGNEE ET SON PROCEDE DE FABRICATION**
MIKROWELLENTRANSISTOR MIT FAST SELBSTJUSTIERTER STRUKTUR UND VERFAHREN ZUR HERSTELLUNG
HYPERFREQUENCY TRANSISTOR WITH QUASI-ALIGNED STRUCTURE AND METHOD FOR MAKING SAME

(30) Priorité: 11.06.1997 FR 9707237
(43) Date de publication de la demande: 05.04.2000
(73) Titulaire: COMMISSARIAT A L'ENERGIE ATOMIQUE, 75015 Paris (FR); FRANCE TELECOM, 75015 Paris (FR)
(72) Inventeur: CHANTRE, Alain, F-38180 Seyssins (FR); DU PORT DE PONCHARA, Jean, F-38950 Quaix-en-Chartreuse (FR)
(74) Mandataire: Ilgart, Jean-Christophe
(86) Numéro de dépôt international: FR9801183
(87) Numéro de publication internationale: WO98057367

(56) Documents cités:
- EP-A- 0 721 222
- EP-A- 0 729 177
- HAYDEN J D ET AL: "AN ULTRA-SHALLOW LINK BASE FOR A DOUBLE POLYSILICON BIPOLAR TRANSISTOR" PROCEEDINGS OF THE BIPOLAR/BICMOS CIRCUITS AND TECHNOLOGY MEETING, MINNEAPOLIS, OCT. 7 - 8, 1992,5 octobre 1992, pages 96-99, XP000340155 INSTITUTE OF ELECTRICAL AND ELECTRONICS ENGINEERS cité dans la demande
- HAYDEN J D ET AL: "A NEW TECHNIQUE FOR FORMING A SHALLOW LINK BASE IN A DOUBLE POLYSILICON BIPOLAR TRANSISTOR" IEEE TRANSACTIONS ON ELECTRON DEVICES, vol. 41, no. 1, 1 janvier 1994, pages 63-68, XP000423610 cité dans la demande

## Description

### Domaine technique

La présente invention concerne un transistor bipolaire du type à structure quasi-autoalignée et un procédé de réalisation d'un tel transistor. Elle concerne de façon plus particulière la fabrication de transistors bipolaires hyperfréquence. Ainsi, l'invention s'inscrit dans le domaine technique de la microélectronique sur silicium, notamment pour la fabrication de circuits intégrés bipolaires et BiCMOS (Bipolar Complementary Metal Oxyde Semiconductor).

L'invention trouve des applications dans la réalisation de circuits logiques, analogiques et en particulier de circuits radiofréquence.

### Etat de la technique antérieure

On connaît à l'heure actuelle des transistors dits à structure double-polysilicium autoalignée. Ces transistors figurent parmi les plus performants du point de vue de la rapidité de fonctionnement. Leur grande vitesse de fonctionnement est justement liée au caractère autoaligné des parties constitutives de ces transistors, qui garantit la précision de leur agencement. De plus, la structure autoalignée permet d'obtenir des transistors de dimensions réduites parfaitement adaptés la réalisation de circuits intégrés. On peut se reporter à ce sujet aux documents (1) et (2) dont les références sont indiquées à la fin de la présente description.

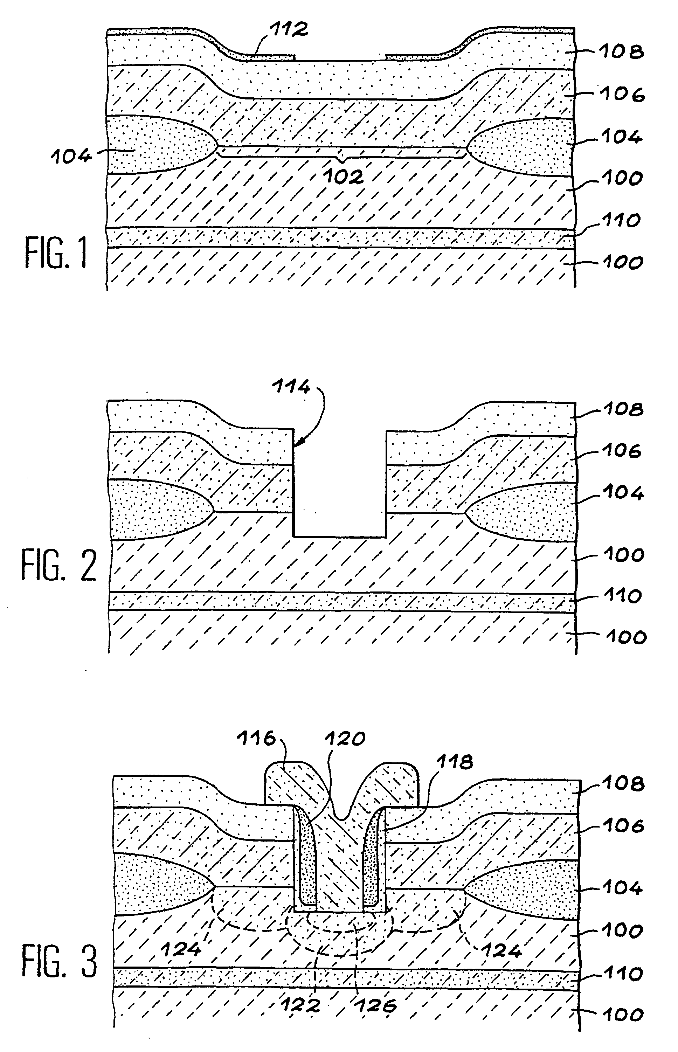

La structure et la fabrication d'un transistor bipolaire du type mentionné ci-dessus sont sommairement décrits en référence aux figures 1 à 3 annexées.

Sur un substrat 100 en silicium, on délimite d'abord une région de formation de transistor 102 en réalisant des pavés d'oxyde de silicium épais 104 désignés par "LOCOS" (Local Oxidation of Silicon), à la surface du substrat. Puis, une première couche de silicium polycristallin 106 dopée au bore et une couche d'isolation 108 en oxyde de silicium ou en nitrure de silicium sont successivement formées à la surface du substrat de silicium.

La référence 110 sur la figure 1 désigne une couche N⁺, dopée à l'arsenic, enterrée dans le substrat 100. Cette couche constitue le collecteur du transistor qui est réalisé ultérieurement.

Un masque de gravure 112 est formé au-dessus de la couche d'isolation 108. Le masque présente une ouverture qui définit l'emplacement futur de l'émetteur du transistor.

Une étape suivante, illustrée à la figure 2, consiste à pratiquer une fenêtre 114 à travers la couche de silicium polycristallin 106 et la couche d'isolation 108 afin de mettre à nu une portion du substrat de silicium 100. L'emplacement de la fenêtre est déterminé par l'ouverture du masque 112 formé sur la couche d'isolation 108.

La fenêtre 114 est réalisée selon une technique de gravure ionique réactive anisotrope. La profondeur de la gravure est ajustée notamment en sélectionnant le temps de gravure.

Or, il s'avère que lorsque le temps de gravure est insuffisant, une partie de la couche de silicium polycristallin dopée 106 demeure au fond de la fenêtre 114. Dans ce cas, la base du transistor, réalisée ultérieurement, se situe dans cette partie de couche de silicium polycristallin et le transistor finalement obtenu est inopérant parce qu'il présente un gain nul.

Pour éviter cette situation, le temps de gravure est choisi suffisant pour garantir l'élimination complète du silicium polycristallin dans la fenêtre. Or, dans ce cas, le silicium du substrat est également attaqué et la fenêtre 114 s'étend en partie dans le substrat 100. Ce phénomène visible à la figure 2, est désigné dans la suite du texte par "surgravure".

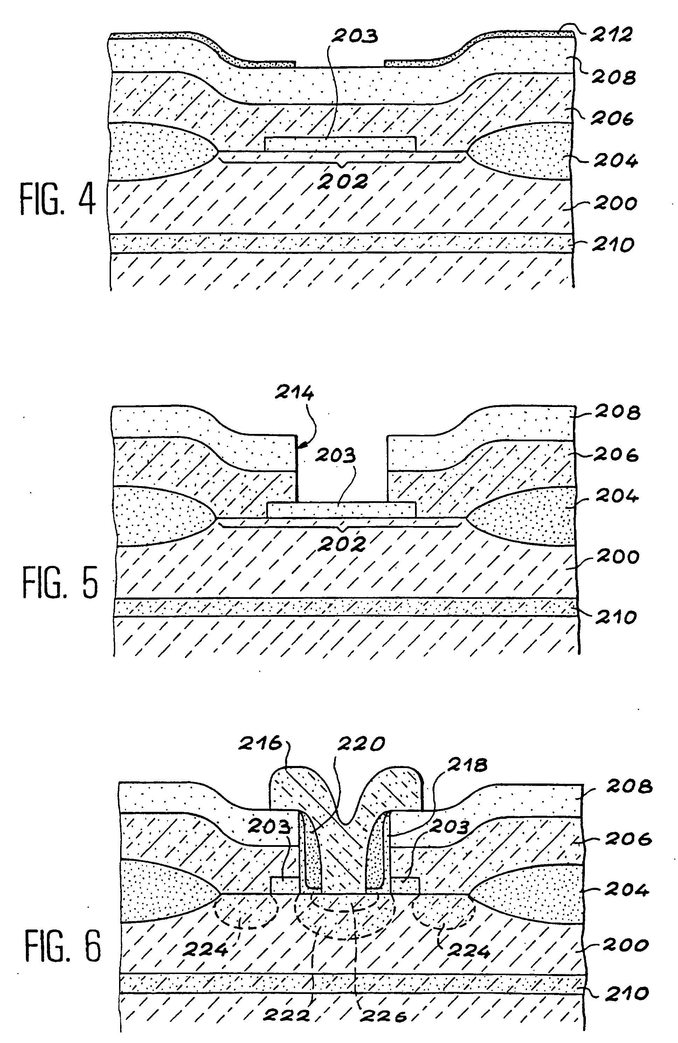

Une étape suivante, illustrée à la figure 3, comporte pour l'essentiel la fabrication de l'émetteur du transistor dans la fenêtre 114. L'émetteur comporte une couche de silicium polycristallin 116 de type N⁺ dopée à l'arsenic. Il est isolé électriquement des flancs de la fenêtre 114 par une couche d'oxyde thermique mince 118 et des espaceurs latéraux 120 recouvrant les flancs. L'émetteur est par ailleurs isolé de la première couche 106 de silicium polycristallin par la couche d'isolation 108.

Il convient de préciser que préalablement à la formation de la couche de silicium polycristallin 116 de l'émetteur, des ions de bore sont implantés dans le substrat 100 à travers la fenêtre 114. Cette implantation permet de créer dans le substrat une région de base désignée par base intrinsèque. Cette région est indiquée sur la figure 3 avec la référence 122.

Le traitement thermique mis en oeuvre pour la réalisation de la couche d'oxyde thermique 118 ou un autre traitement thermique mis en oeuvre après la réalisation de l'émetteur, provoquent la diffusion d'impuretés dopantes depuis la première couche de silicium polycristallin 106 et depuis la couche de silicium polycristallin 116 formant l'émetteur, dans le substrat de silicium.

La diffusion d'impuretés, et en particulier de bore, de la première couche de silicium polycristallin 106 dans le substrat permet d'y former des régions dopées appelées "base extrinsèque" dans la suite du texte. Ces régions sont indiquées avec la référence 124 sur la figure 3. Par ailleurs, la diffusion d'arsenic de la couche de silicium polycristallin 116 de l'émetteur dans le substrat 100 prolonge l'émetteur d'une région d'émetteur en contact avec la région de base intrinsèque 122. La région d'émetteur diffusée dans le substrat est représentée sur la figure 3 avec la référence 126.

On peut noter sur la figure 3 que les régions de base extrinsèque et intrinsèque se chevauchent légèrement. Un tel chevauchement est nécessaire pour assurer une continuité électrique entre les bases extrinsèque 124 et intrinsèque 122 et pour permettre un adressage de la base intrinsèque. En effet, une prise de contact de base, non visible sur la figure 3, est réalisée sur la première couche de silicium polycristallin dopé qui est en contact avec la base extrinsèque 124.

La région de base extrinsèque 124 et l'émetteur sont des régions fortement dopées. Il est par conséquent essentiel que ces régions soient suffisamment éloignées l'une de l'autre pour éviter des risques de fuites électriques du transistor.

Le procédé de fabrication de transistors bipolaires décrit ci-dessus et les transistors obtenus par ce procédé présentent un certain nombre de problèmes qui influent de façon négative sur leurs performances et sur le rendement de fabrication des circuits intégrés qui comportent de tels transistors.

En effet, lorsque la surgravure de la fenêtre 114 (figure 2) est très profonde, la zone diffusée formant la base extrinsèque n'atteint plus la partie du substrat sous l'émetteur. Il y a alors un risque de supprimer le contact électrique entre les bases extrinsèque et intrinsèque. Si tel est le cas, la base intrinsèque reste sans accès électrique. De plus, une surgravure importante réduit notablement la distance entre la base intrinsèque 122 et la couche de collecteur 110 (figure 3) enterrée. Ceci réduit la tenue en tension entre la base et le collecteur et un claquage ou une avalanche base-collecteur risque de se produire dans le transistor.

Par ailleurs, la gravure de la fenêtre 114 et la surgravure dans le silicium du substrat induit des défauts d'ordre cristallographique à l'interface émetteur-base. Ces défauts engendrent un courant de fuite de la jonction émetteur-base qui dégrade le gain en courant du transistor. De plus, le caractère anisotrope de la gravure de la fenêtre 114, donne une interface émetteur-base rugueuse. Cette rugosité à une influence sur le résultat des traitements chimiques que subit le substrat pendant le procédé de réalisation du transistor. Par exemple, il peut y avoir une incidence négative sur la vitesse d'oxydation ou sur la qualité du nettoyage entre les différentes étapes de fabrication. L'influence de la rugosité n'est pas contrôlable.

Ainsi, les structures auto-alignées décrites ci-dessus posent pour l'essentiel le problème de surgravure de la fenêtre d'émetteur. Or, pour éviter une surgravure importante, il est nécessaire d'effectuer un contrôle précis de la gravure du silicium polycristallin, ce qui s'avère délicat dans le cadre d'une production industrielle.

Afin de faciliter la fabrication des transistors, tout en évitant une surgravure du substrat et les difficultés mentionnées ci-dessus, un autre procédé de fabrication dit "quasi-autoaligné" est également connu. Ce procédé est décrit ci-après en référence aux figures 4 à 6.

En raison d'une grande similitude entre les structures représentées aux figures 4 à 6 avec celles des figures 1 à 3, une partie de la description qui précède n'est pas reprise. On pourra toutefois s'y référer pour une meilleure intelligence des dessins. Par ailleurs, pour des raisons de commodité, des éléments identiques ou similaires à ceux des figures 1 à 3 portent les mêmes références, auxquelles on a ajouté 100.

La structure représentée à la figure 4 se distingue de celle de la figure 2, pour l'essentiel, par une vignette 203 déposée sur le substrat 200 dans la zone de formation de transistor 202. La vignette 203 est une couche d'oxyde de silicium d'une épaisseur de l'ordre de 20 à 50 nm. Elle a une fonction de couche d'arrêt de gravure expliquée plus loin. La formation de la vignette 203 a lieu après celle des pavés d'isolant épais 204 qui délimitent la zone de formation du transistor 202, et avant le dépôt de la couche de silicium polycristallin dopé 206 et de la couche d'isolation 208.

Sur la figure 4, on peut noter également la présence d'une couche 210 formant collecteur, enterrée dans le substrat 200, et un masque de gravure 212 formé sur la couche d'isolation 208 pour définir l'emplacement de la gravure de la fenêtre d'émetteur. A cet effet, le masque 212 présente une ouverture de gravure située au-dessus de la vignette 203.

La surface de la vignette 203 est supérieure aux dimensions de l'ouverture prévue dans le masque pour la gravure de la fenêtre d'émetteur. Ainsi, ce débordement entre l'ouverture du masque et de la vignette est compatible avec les possibilités d'alignement des photorépéteurs, qui est typiquement de 0,2 µm..

Une étape suivante, illustrée par la figure 5, est la gravure d'une fenêtre d'émetteur 214 à travers la couche de silicium polycristallin dopé 206 et à travers la couche d'isolation 208. Cette gravure, par exemple une gravure à ions réactifs, est arrêtée par la vignette 203. On peut noter à ce sujet que la couche d'oxyde de silicium formant la vignette est réalisée suffisamment épaisse pour garantir l'arrêt de gravure et empêcher toute surgravure du substrat 200.

Après la gravure du silicium polycristallin, une désoxydation permet également d'éliminer la partie de la vignette mise à nu au fond de la fenêtre d'émetteur.

Ces opérations sont suivies par une implantation d'une région de base intrinsèque 222 au fond de la fenêtre d'émetteur, par la formation d'une couche d'oxyde thermique 218 et d'espaceurs 220 sur les flancs de la fenêtre d'émetteur et enfin par la formation d'une couche de silicium polycristallin dopée 216 formant l'émetteur dans la fenêtre d'émetteur. Ces parties sont visibles à la figure 6.

Comme le montre en outre la figure 6, un traitement thermique, par exemple pour la formation de la couche d'oxyde thermique 218, permet de faire diffuser les espèces dopantes de la couche de silicium polycristallin 206 dans le substrat 200 pour y former les régions de base extrinsèque 224 telles que déjà décrites en référence à la figure 3.

Toutefois, contrairement à la structure de la figure 3, on peut noter que dans la structure de la figure 6 il existe le risque qu'il n'y ait pas de contact entre les zones de base intrinsèque 222 et extrinsèque 224. Ce défaut de contact est dû à un décalage résultant de la partie de la vignette 203 restant à la surface du substrat. En effet, la partie restante de la vignette 203, en dehors de la fenêtre d'émetteur empêche la diffusion des impuretés dopantes de la couche de silicium polycristallin dopé 206 dans le substrat 200 sous-jacent.

Si tel est le cas, le transistor est inopérant car il n'y a plus d'accès électrique à la base intrinsèque.

Pour éviter ce phénomène, il faudrait réduire les dimensions de la vignette 203 pour qu'elle ne dépasse pratiquement pas de la fenêtre d'émetteur.

Cette solution n'est cependant pas avantageuse dans le cadre d'une réalisation industrielle car elle rend critique l'alignement entre l'ouverture du masque et la vignette.

Une autre solution est de former une région de base dans toute la zone de fabrication de transistor 202 (voir figure 4) par implantation d'impuretés dopantes appropriées dans le substrat de silicium. Cette implantation est effectuée dans ce cas avant la réalisation de la vignette et des autres couches décrites ci-dessus.

Un tel procédé permet non seulement d'éviter une surgravure du substrat grâce à la vignette mais garantit aussi un contact électrique vers la base du transistor.

Toutefois, lorsque la base est réalisée lors des premières étapes de fabrication du transistor, les impuretés dopantes implantées dans le substrat pour former la base continuent à diffuser pendant les étapes ultérieures et notamment pendant les étapes nécessitant un traitement thermique.

Cette diffusion supplémentaire des impuretés dopantes déjà implantées dans le substrat provoque un élargissement de la région de base du transistor. Or, lorsque la base est plus large le transistor perd en rapidité de fonctionnement, parce que le temps de transit des électrons dans la base augmente.

La fréquence de fonctionnement des circuits comprenant de tels transistors en est ainsi réduite.

Les documents (3) et (4) dont les références sont également précisées à la fin de la présente description, décrivent par ailleurs des transistors comprenant une base de liaison entre une base intrinsèque et une base extrinsèque.

### Exposé de l'invention.

La présente invention a pour but de proposer un procédé de fabrication d'un transistor bipolaire ne présentant pas les difficultés exposées ci-dessus.

Un but est en particulier d'éviter les problèmes de la surgravure du substrat lors de la gravure de la fenêtre d'émetteur et les problèmes d'alignement entre le masque de gravure et une vignette d'arrêt de gravure.

Un but est également d'éviter une diffusion excessive des régions de base et les pertes de vitesse de fonctionnement du transistor qui en résultent.

Un but est encore de garantir un accès électrique à la base et en particulier à une région de base intrinsèque en contact avec l'émetteur.

Enfin, un but est de proposer un transistor peu coûteux et adapté à une réalisation industrielle de circuits intégrés.

Pour atteindre ces buts, l'invention a plus précisément pour objet un procédé de fabrication d'un transistor bipolaire sur un substrat de silicium avec une couche de collecteur enterrée, comprenant les étapes successives suivantes :
a) réalisation d'une première couche dite de vignette en oxyde thermique non dopé, recouvrant une partie d'une région de formation de transistor du substrat,
b) formation d'une première couche de silicium polycristallin dopé recouvrant la région de formation de transistor et la première couche de vignette, et d'une couche d'isolation électrique recouvrant la couche de silicium polycristallin dopé,
c) gravure de la couche d'isolation électrique et de la première couche de silicium polycristallin dopé avec arrêt sur la première couche de vignette afin d'y pratiquer une fenêtre, dite fenêtre d'émetteur, au-dessus d'une partie de la première couche de vignette,
d) implantation d'impuretés dopantes pour former une région de base, dite intrinsèque, dans le substrat sous la fenêtre d'émetteur, et élimination locale de la première couche de vignette dans la fenêtre d'émetteur,
e) isolation latérale des flancs de la fenêtre d'émetteur et formation d'une deuxième couche de silicium polycristallin, dite couche d'émetteur,
le procédé comprenant en outre au moins une étape de traitement thermique pour former une région de base, dite extrinsèque, par diffusion dans le substrat d'impuretés dopantes de la première couche de silicium polycristallin dopée, en dehors d'une région recouverte par la première couche de vignette, et pour former une région de base, dite de liaison, reliant les régions de base extrinsèque et intrinsèque, par diffusion d'impuretés dopantes dans le substrat à travers la première couche de vignette, la première couche de vignette étant réalisée avec une épaisseur suffisamment importante pour constituer une couche d'arrêt de gravure lors de l'étape c) et suffisamment mince pour autoriser une diffusion d'impuretés à travers cette couche lors de l'étape de traitement thermique.

Grâce à la diffusion des espèces dopantes à travers la première couche de vignette, subsistant autour de la fenêtre d'émetteur, un lien électrique entre les bases extrinsèque et intrinsèque est assuré, indépendamment de la taille de la couche de vignette.

La vignette peut ainsi être dimensionnée de telle façon que la gravure de la couche d'isolation ne soit pas critique.

En outre, la première couche de vignette permet d'éviter une surgravure du substrat et les problèmes engendrés par une telle surgravure.

A titre d'exemple, la première couche de vignette peut être une couche d'oxyde de silicium d'une épaisseur comprise entre 3 et 10 nm.

L'utilisation d'un oxyde thermique non dopé pour la réalisation de la première couche de vignette est importante pour garantir un bon fonctionnement durable du transistor.

L'oxyde thermique non dopé permet d'éviter un contact direct entre la source de dopage, formée par le silicium polycristallin dopé, et le silicium dans la région intrinsèque du transistor. Ainsi tout risque de contamination involontaire en bore de cette région est écarté.

Par ailleurs, l'utilisation d'un oxyde thermique garantit une bonne qualité d'interface silicium/oxyde dans la zone active et en particulier là où débouche la jonction émetteur-base. En effet, l'oxyde thermique, contrairement à un oxyde déposé (moins dense), se dégrade moins rapidement sous l'action de porteurs chauds lors d'une polarisation en inverse de la jonction émetteur-base. La durée de fonctionnement du transistor se trouve ainsi considérablement augmentée.

Accessoirement, lors de la formation de la première couche de vignette, l'oxyde thermique peut également être mis à profit pour la réalisation de l'isolant de grille de transistor MOS, dans le cas de la réalisation de structures BiCMOS combinant des transistors bipolaires et MOS. Dans ce cas, le silicium polycristallin formé ultérieurement peut servir également à la réalisation des grilles des transistors MOS.

Selon une mise en oeuvre avantageuse du procédé, le traitement thermique peut avoir lieu pendant l'étape e), lors d'une formation d'une couche d'oxyde thermique recouvrant les flancs de la fenêtre d'émetteur.

Ainsi, un unique traitement thermique permet à la fois de former une couche d'oxyde thermique qui recouvre les parois de la fenêtre d'émetteur et de faire diffuser les impuretés dopantes de la couche de silicium polycristallin dans le substrat pour former les régions de base extrinsèque et de liaison. La couche d'oxyde thermique est éliminée du fond de la fenêtre avant la formation de la couche d'émetteur.

Selon un perfectionnement, l'étape a) du procédé peut comporter, en outre, la formation d'une deuxième couche de vignette recouvrant la première couche de vignette, la deuxième couche de vignette étant en polysilicium dopé et constituant un réservoir d'impuretés dopantes pour la formation de la région de base de liaison.

Ce perfectionnement est particulièrement avantageux. Il permet en effet, en ajustant respectivement le dopage de la première couche de silicium polycristallin et de la deuxième couche de vignette, de contrôler indépendamment la concentration de dopants dans les régions de base intermédiaire et de base de liaison.

En particulier, un dopage plus important de la deuxième couche de vignette, permet de compenser l'arrêt partiel des impuretés par la première couche de vignette, et d'obtenir ainsi des régions de base extrinsèque et de liaison avec une concentration sensiblement uniforme.

De façon avantageuse, la première couche de vignette peut être une couche d'oxyde de silicium (SiO₂), et la deuxième couche de vignette une couche de silicium polycristallin dopé au fluorure de bore (BF₂).

La présence de fluor dans la deuxième couche de vignette facilite la diffusion du bore à travers la première couche de vignette.

L'invention a également pour objet un transistor bipolaire comprenant à la surface d'un substrat de silicium, une base, dite extrinsèque, surmontée par une première couche de silicium polycristallin dopé, une base dite intrinsèque, séparée de la base extrinsèque et surmontée par une deuxième couche de silicium polycristallin, formant émetteur, et isolée de la première couche de silicium polycristallin, et une troisième base, dite de liaison, reliant la base extrinsèque à la base intrinsèque. Conformément à l'invention, la base de liaison est pour l'essentiel située sous la première couche de silicium polycristallin dopé.

Comme la base de liaison est située sous la première couche de silicium dopé, le contact entre la base extrinsèque et la base intrinsèque est garanti.

Un tel transistor peut être obtenu avec un procédé tel qu'indiqué précédemment.

Selon un aspect particulier, le transistor peut comporter en outre une couche d'oxyde de silicium séparant la base de liaison de la première couche de silicium polycristallin.

Ceci est le cas notamment lorsque la première couche de vignette, réalisée lors du procédé de fabrication, est largement dimensionnée.

Lorsqu'une deuxième couche de vignette est réalisée, le transistor comporte en outre une couche additionnelle de silicium polycristallin dopé, disposée sur la couche d'oxyde de silicium et séparant la base de liaison de la première couche de silicium polycristallin.

D'autres caractéristiques et avantages de l'invention ressortiront mieux de la description qui va suivre, en référence aux figures des dessins annexés. Cette description est donnée à titre purement illustratif et non limitatif.

### Brève description des figures

- les figures 1 à 3, déjà décrites, sont des coupes schématiques de la structure d'un transistor bipolaire lors d'étapes successives d'un procédé de fabrication connu,
- les figures 4 à 6, déjà décrites, sont des coupes schématiques de la structure d'un transistor bipolaire lors d'étapes successives d'un autre procédé de fabrication connu,
- les figures 7 à 10 sont des coupes schématiques de la structure d'un transistor bipolaire lors d'étapes successives de fabrication, conformément à une mise en oeuvre particulière du procédé de l'invention. La figure 10 montre également en coupe la structure d'un transistor conforme à l'invention obtenu au terme du procédé.

### Description détaillée d'un mode de mise en oeuvre de l'invention

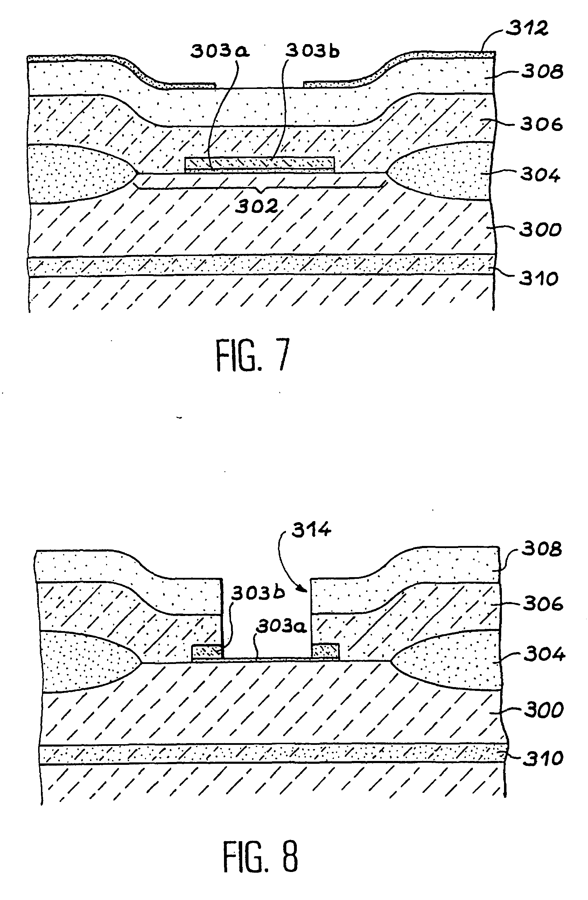

Sur les figures 7 à 10 décrites ci-après, des parties identiques ou similaires à des parties des figures 4 à 6 portent les mêmes références auxquelles on a ajouté 100.

Comme le montre la figure 7, la fabrication du transistor débute par la formation de pavés d'oxyde épais 304 qui délimitent sur un substrat en silicium 300 une région 302 de formation de transistor. Cette région présente des dimensions de l'ordre de 1,1 à 1,8 µm.

Les pavés 304 sont formés par oxydation locale du silicium du substrat selon une technique connue en soi et usuellement désignée par "LOGOS". Leur épaisseur est de l'ordre de 0,5 à 0,6 µm.

Vient ensuite le dépôt et la mise en forme de deux couches successives respectivement d'oxyde de silicium et de silicium polycristallin, afin de former des vignettes indiquées avec les références 303a et 303b. Ces vignettes sont mises en forme selon des procédés usuels de photolithographie.

La première couche de vignette est une couche d'oxyde de silicium dont l'épaisseur est comprise entre 3 et 10 nm et de préférence égale à 5 nm. L'épaisseur de la couche est ajustée afin de permettre une diffusion ultérieure d'impuretés dopantes à travers la couche tout en conservant des propriétés d'arrêt de gravure exposées plus loin.

La deuxième couche de vignette 303b est une couche de silicium polycristallin d'une épaisseur de l'ordre de 30 nm à 50 nm, par exemple. Elle est dopée au fluorure de bore BF₂. La concentration en impuretés dopantes est par exemple de 10¹⁹ à 10²⁰cm⁻³.

Une première couche de silicium polycristallin 306 dopée P⁺, au bore, est ensuite déposée sur le substrat 300 afin de recouvrir les vignettes 303a, 303b, mais aussi l'ensemble de la zone de fabrication de transistor 302. La première couche de silicium polycristallin 306 présente une épaisseur de l'ordre de 100 à 300 nm et une concentration d'impuretés de bore de l'ordre de 10¹⁹ à 10²⁰ cm⁻³.

Une couche 308 d'oxyde ou de nitrure de silicium est ensuite déposée sur l'ensemble de la première couche de silicium polycristallin. La couche d'oxyde ou de nitrure de silicium est une couche d'isolation électrique. Elle présente également une épaisseur de l'ordre de 100 nm à 300 nm.

Enfin, un masque de gravure 312, en résine photosensible est formé au-dessus de la couche d'isolation 308. Le masque présente une ouverture sensiblement alignée sur les vignettes 303a, 303b. Toutefois, les dimensions de l'ouverture, de l'ordre de 0,5 µm à 0,8 µm, sont choisies de préférence légèrement inférieures à celles des vignettes de sorte que l'alignement ne soit pas critique.

Par ailleurs, l'ouverture du masque 312, de même que les vignettes 303a, 303b sont prévues sensiblement au centre de la zone 302 de formation du transistor.

Une gravure successive des couches d'isolation 308 et de silicium polycristallin 306, 303b, à travers l'ouverture du masque permet d'y pratiquer une fenêtre 314 dite fenêtre d'émetteur. La gravure, par exemple une gravure ionique réactive anisotrope est arrêtée par la première couche de vignette 303a en oxyde de silicium. Comme le montre la figure 8, cette couche est mise à nu au fond de la fenêtre 314.

La fenêtre d'émetteur présente un diamètre de l'ordre de 0,5 à 0,8 µm. Lorsqu'elle est centrée dans la zone de fabrication de transistor 302, elle reste séparée des pavés d'oxyde 304 d'une distance de l'ordre de 0,3 à 0,5 µm.

Après la gravure de la fenêtre d'émetteur 314 l'oxyde de silicium de la première couche de vignette, mise à nu au fond de la fenêtre, peut être éliminé. Le masque de gravure 312 l'est également.

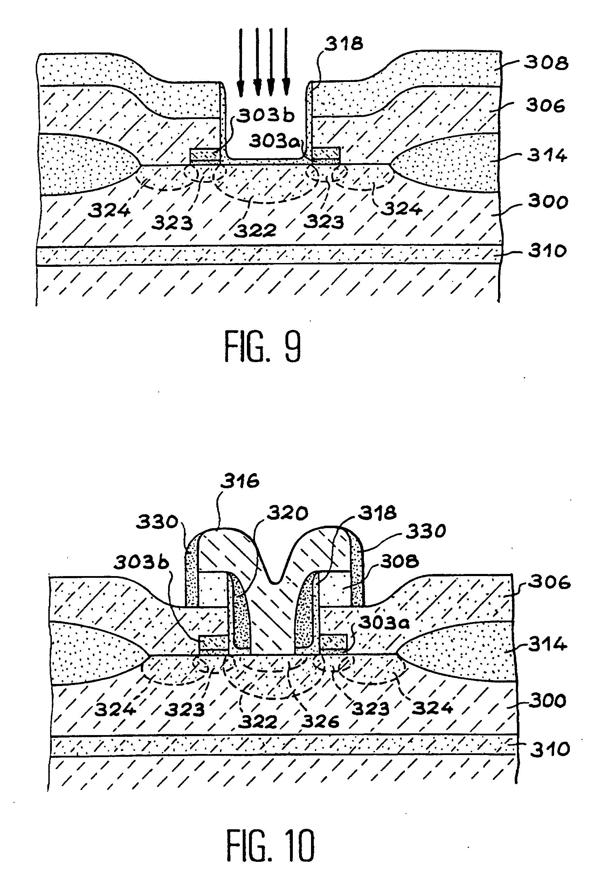

Comme le montre la figure 9, une fine couche d'oxyde 318, par exemple d'oxyde thermique est formée afin de tapisser l'ensemble des parois de la fenêtre d'émetteur et notamment les flancs latéraux.

Par ailleurs, une implantation d'ions, de bore, à basse énergie, de l'ordre de 5 à 20 KeV, par exemple 7 KeV, a lieu dans la fenêtre 314 afin de former dans le substrat 300, sous la fenêtre, une région de base intrinsèque 322. La concentration en impuretés dopantes de cette région est de l'ordre de 10¹⁸cm⁻³. Sur la figure 9, l'implantation est représentée sommairement par des flèches.

Un traitement thermique effectué à une température de l'ordre de 700°C à 950°C, avantageusement à 850°C, pendant quelques minutes peut être mis à profit pour la formation de la couche d'oxyde thermique 318 mentionné ci-dessus. Ce traitement thermique permet également la diffusion du bore de la première couche de silicium polycristallin 306 dans le substrat 300 pour y former des régions dites de base extrinsèque 324. La concentration en impuretés dopantes de ces régions est de l'ordre de 10²⁰cm⁻³.

Le traitement thermique permet également la diffusion de bore de la deuxième couche de vignette 303b, subsistant de part et d'autre de la fenêtre d'émetteur 314, dans le substrat 300, à travers la partie restante de la première couche de vignette 303a. Cette diffusion, facilitée par la présence de fluor, permet de former des régions dopées 323 dites "base de liaison".

La concentration d'impuretés dopantes dans les bases de liaison est de l'ordre de 5.10¹⁹cm⁻³ à 8.10¹⁹cm⁻³. Ces bases de liaison assurent une continuité électrique entre les bases intrinsèque et extrinsèque.

Une étape suivante, illustrée à la figure 10 comprend la formation de l'émetteur dans la fenêtre d'émetteur.

Afin d'éviter tout contact électrique avec la première couche de silicium polycristallin 306 des espaceurs latéraux 320 de nitrure de silicium sont formés sur les flancs de la fenêtre d'émetteur, sur la couche d'oxyde thermique 318. Les espaceurs sont formés par le dépôt d'une couche de nitrure de silicium suivi d'une gravure anisotrope de cette couche.

Lorsque les espaceurs latéraux 320 sont achevés, la fenêtre d'émetteur 314 est désoxydée (pour éliminer l'oxyde thermique dans le fond) et une nouvelle couche de silicium polycristallin 316 est formée.

Cette couche de silicium polycristallin 316, dite couche d'émetteur, est dopée à l'arsenic avec une concentration de l'ordre de 10²⁰cm⁻³. Son épaisseur est de l'ordre de 200 à 400 nm.

La couche d'émetteur 316, de même que la couche d'isolation 308 sous-jacente, sont ensuite mises en forme dans une nouvelle étape de photolithographie. Les flancs extérieurs de la couche d'émetteur 316 peuvent être protégés par une couverture de flanc isolante de nitrure ou d'oxyde de silicium. Cette couverture est indiquée avec la référence 330 sur la figure 10.

Un nouveau traitement thermique peut encore être mis en oeuvre. Ce traitement thermique effectué de préférence à une température de 950 à 1050°C avec une durée de l'ordre de 5 à 20 s (par exemple 1025°C pendant 20 secondes) achève la diffusion des régions de base 322, 323, 324, déjà décrites, et provoque une diffusion d'une région 322, dopée N qui prolonge la couche d'émetteur dans le substrat 300. Cette région est désignée par région d'émetteur et porte la référence 326.

On peut noter sur la figure 10 que dans le transistor finalement obtenu la base de liaison 323 est pour l'essentiel située sous la première couche de silicium polycristallin dopé 306 et en est séparée par une couche d'oxyde de silicium provenant de la première vignette 303a, et par une couche de silicium polycristallin 303b provenant de la deuxième vignette.

Des différences de concentration de dopage entre la première couche de silicium polycristallin 306 et la couche de silicium polycristallin de la deuxième vignette 303b permettent, comme évoqué dans la première partie de la description, d'ajuster précisément et indépendamment les concentrations de bases extrinsèque et de liaison.

La description qui précède a été donnée pour un transistor bipolaire de type NPN. Pour la réalisation d'un transistor PNP les dopages de type P sont simplement remplacés par des dopages de type N et vice-versa.

La fabrication des transistors peut par ailleurs être complétée par la réalisation de prises de contact sur les régions de base, d'émetteur et de collecteur et la réalisation de lignes de liaison électriques entre les transistors afin de former des circuits intégrés.

### DOCUMENTS CITES

***1)***
   A new technique for forming a shallow link base in a double polysilicon bipolar transistor
   J.D. hayden, Senior Member, IEEE, J.D. Burnett, J.R. Pfiester, Senior Member, IEE, And M.P. Woo
   IEEE transactions on electron devices, vol. 41, n°1 January 1994, pages 63-67.
***2)***
   An Ultra-Shallow link base of a double polysilicon bipolar transistor
   J.D. Hayden, J.D. Burnett, J.R. Pfiester, and M.P. Woo, Advanced Products Research and Development Laboratory, Motorola Inc.,
   IEEE 1992 Bipolar Circuits and Technology Meeting 4.5, pages 96-99.
***3)***
   EP-A-721 222
***4)***
   EP-A-729-177

## Revendications

1. Procédé de fabrication d'un transistor bipolaire sur un substrat de silicium (300) avec une couche de collecteur (310) enterrée, comprenant les étapes successives suivantes :
a) réalisation d'une première couche (303a), dite de vignette en oxyde thermique non dopé, recouvrant une partie d'une région (302) de formation de transistor du substrat,
b) formation d'une première couche (306) de silicium polycristallin dopé recouvrant la région (302) de formation de transistor et la première couche de vignette, et d'une couche (308) d'isolation électrique recouvrant la couche de silicium polycristallin dopé,
c) gravure de la couche d'isolation électrique (308) et de la première couche (306) de silicium polycristallin dopé avec arrêt sur la première couche de vignette (303a) afin d'y pratiquer une fenêtre (314), dite fenêtre d'émetteur, au-dessus d'une partie de la première couche de vignette (303a),
d) implantation d'impuretés dopantes pour former une région de base (322), dite intrinsèque, dans le substrat sous la fenêtre d'émetteur (314) et élimination locale de la première couche de vignette (303a) dans la fenêtre d'émetteur,
e) isolation latérale des flancs de la fenêtre d'émetteur et formation d'une deuxième couche de silicium polycristallin (316), dite couche d'émetteur,
le procédé comprenant en outre au moins une étape de traitement thermique pour former une région de base (324) dite extrinsèque par diffusion d'impuretés dopantes de la première couche (306) de silicium polycristallin dopée, dans le substrat, en dehors d'une région recouverte par la première couche de vignette (303a) et pour former une région de base (323), dite de liaison, reliant les régions de base extrinsèque (303a) et intrinsèque (322), par diffusion d'impuretés dopantes dans le substrat à travers la première couche de vignette (303a), la première couche de vignette étant réalisée avec une épaisseur suffisamment importante pour constituer une couche d'arrêt de gravure lors de l'étape c) et suffisamment mince pour autoriser une diffusion d'impuretés à travers cette couche lors de l'étape de traitement thermique.

2. Procédé selon la revendication 1, dans lequel la première couche de vignette (303a) est une couche d'oxyde de silicium d'une épaisseur comprise entre 3 et 10 nm.

3. Procédé selon la revendication 1, dans lequel le traitement thermique a lieu pendant l'étape e), lors d'une formation d'une couche d'oxyde thermique (318) recouvrant les flancs de la fenêtre d'émetteur (314).

4. Procédé selon la revendication 1, dans lequel l'étape a) comporte en outre la formation d'une deuxième couche de vignette (303b) recouvrant la première couche de vignette (303a), la deuxième couche de vignette (303b) étant en polysilicium dopé et constituant un réservoir d'impuretés dopantes pour la formation de la région (323) de base de liaison.

5. Procédé selon la revendication 4, dans lequel la première couche de vignette (303a) est une couche d'oxyde de silicium (SiO₂) et dans lequel la deuxième couche de vignette (303b), en silicium polycristallin, est dopée au fluorure de bore (BF₂).

6. Transistor bipolaire comprenant à la surface d'un substrat de silicium (300) une base (324), dite extrinsèque, surmontée par une première couche (306) de silicium polycristallin dopé, une base (322) dite intrinsèque, séparée de la hase extrinsèque (324) et surmontée par une deuxième couche (316) de silicium polycristallin, formant émetteur, et isolée de la première couche (306) de silicium polycristallin, et une troisième base (323), dite de liaison, reliant la base extrinsèque (324) à la base intrinsèque (322), la base de liaison (323) étant pour l'essentiel située sous la première couche (306) de silicium polycristallin dopé, **caractérisé en ce que** le transistor comprend en outre une couche d'oxyde thermique de silicium, non dopée, (303a) séparant la base de liaison (323) de la première couche de silicium polycristallin (306), la couche d'oxyde présentant une épaisseur suffisamment importante pour constituer une couche d'arrêt de gravure et suffisamment mince pour autoriser une diffusion thermique d'impuretés à travers cette couche.

7. Transistor selon la revendication 6, comprenant en outre une couche additionnelle (303b) de silicium polycristallin dopé, disposée sur la couche d'oxyde de silicium (303a) et séparant la base de liaison (323) de la première couche de silicium polycristallin (306).

8. Transistor selon la revendication 7, dans lequel la couche additionnelle (303b) de silicium polycristallin et la première couche (306) de silicium polycristallin présentent des concentrations de dopage différentes.

## Claims

1. Production method for a bipolar transistor on a silicon substrate (300) with an embedded collector layer (310) comprising the following successive stages:
a) creating a first layer (303a), called a sticker, of undoped thermal oxide that covers part of a transistor formation zone (302) of the substrate,
b) forming a first layer (306) of doped polycrystalline silicon that covers the transistor formation zone (302) and the first layer of sticker, and an electrical insulation layer (308) that covers the layer of doped polycrystalline silicon,
c) etching the electrical insulation layer (308) and the first layer (306) of doped polycrystalline silicon and that stops etching at the first layer of sticker (303a) in order to cut a window (314), called a emitter window, above a section of first layer of sticker (303a),
d) implanting doping impurities to create a base area (322), called an intrinsic base, in the substrate under the emitter window (314) and eliminating the first layer of sticker (303a) from the emitter window,
e) laterally insulating the sides of the emitter window and forming a second layer of polycrystalline silicon (316), called the emitting layer,
the method also comprising at least one thermal treatment stage to create a base area (324), called an extrinsic base, by diffusing doping impurities from the first layer (306) of doped polycrystalline silicon into the substrate, outside an area covered by the first layer of sticker (303a), to create a base area, called a link base, that links the extrinsic base (303a) and the intrinsic base (322), by diffusing doping impurities into the substrate through the first layer of sticker (303a), said first layer of sticker being sufficiently thick to constitute a layer to stop the etching in stage c) and sufficiently thin to enable impurities to be diffused through the layer during the thermal treatment stage.

2. Method of claim 1 wherein the first sticker layer (303a) is a layer of silicon oxide between 3 and 10 nm thick.

3. Method of claim 1 wherein the thermal treatment takes place during stage e) when a thermal oxide layer (318) is formed that covers the sides of the emitter window (314).

4. Method of claim 1 wherein stage a) also includes forming a second layer of sticker (303b) that covers the first layer of sticker (303a), the second layer of sticker (303b) being made of doped polysilicon and constituting a reservoir of doping impurities to create a link base area (323).

5. Method of claim 4, wherein first sticker layer (303a) is a layer of silicon oxide (SiO₂) and wherein the second sticker layer (303b) is a layer of polycrystalline silicon doped with boron fluoride (BF₂).

6. Bipolar transistor comprising a base (324) on the surface of a silicon substrate (300), called an extrinsic base, covered by a first layer (306) of doped polycrystalline silicon, a base (322) called an intrinsic base that is separated from the extrinsic base (324) and covered by a second layer (316) of polycrystalline silicon that constitutes the emitter and that is insulated from the first layer (306) of polycrystalline silicon, and a third base (323), called a link base, that links the extrinsic base (324) to the intrinsic base (322), **characterized in that** most of the link base (323) is located under the first layer (306) of doped polycrystalline silicon, the oxide layer having a sufficiently great thickness to constitute an etching stopping layer and is sufficiently thin to allow a thermal diffusion of impurities through said layer.

7. Transistor of claim 6 also comprising an additional layer (303b) of doped polycrystalline silicon that is deposited on the layer of silicon oxide (303a) and that separates link base (323) from the first layer of polycrystalline silicon (306).

8. Transistor of claim 7, wherein additional layer (303b) of polycrystalline silicon and first layer (306) of polycrystalline silicon have different concentrations of doping.

## Patentansprüche

1. Verfahren zur Herstellung eines bipolaren Transistors auf einem Siliciumsubstrat (300) mit einer vergrabenen Kollektorschicht (310), das die folgenden Schritte umfasst:
a) Herstellen einer ersten sogenannten Vignettenschicht (303a) aus nichtdotiertem thermischem Oxid, die einen Teil einer Transistorbildungszone (302) des Substrats überdeckt,
b) Bilden einer ersten Schicht (306) aus dotiertem polykristallinen Silicium, die die Transistorbildungszone (302) und die erste Vignettenschicht überdeckt, und einer elektrischen Isolationsschicht (308), die die dotierte polykristalline Siliciumschicht überdeckt,
c) Ätzen der elektrischen Isolationsschicht (308) und der ersten Schicht (306) aus dotiertem polykristallinem Silicium mit Stopp auf der ersten Vignettenschicht (303a), um ein Fenster (314) herzustellen, Emitterfenster genannt, über einem Teil der ersten Vignettenschicht (303a),
d) Implantieren von Dotierverunreinigungen, um in dem Substrat einen sogenannten intrinsischen Basisbereich (322) zu bilden, unter dem Emitterfenster (314), und örtliches Entfernen der ersten Vignettenschicht (303a) in dem Emitterfenster,
e) seitliches Isolieren der Flanken des Emitterfensters und Bilden einer zweiten Schicht aus polykristallinem Silicium (316), Emitterschicht genannt,
wobei dieses Verfahren außerdem wenigstens einen Wärmebehandlungsschritt umfasst, um durch Diffusion von Dotierverunreinigungen der ersten Schicht (306) aus dotiertem polykristallinem Silicium einen sogenannten extrinsischen Basisbereich (324) zu bilden, in dem Substrat, außerhalb eines durch die erste Vignettenschicht (303a) bedeckten Bereichs, und um durch Diffusion von Dotierverunreinigungen durch die erste Vignettenschicht (303a) in dem Substrat einen sogenannten Verbindungsbasisbereich (323) zu bilden, der den extrinsischen Basisbereich (324) und den intrinsischen Basisbereich (322) verbindet, wobei die erste Vignettenschicht ausreichend dick ausgebildet wird, um im Schritt c) eine Ätzsperrschicht zu bilden, und ausreichend dünn, um während des Wärmebehandlungsschritts eine Diffusion von Verunreinigungen durch diese Schicht hindurch zu ermöglichen.

2. Verfahren nach Anspruch 1, bei dem die erste Vignettenschicht (303a) eine Siliciumdioxidschicht mit einer Dicke zwischen 3 und 10 nm ist.

3. Verfahren nach Anspruch 1, bei dem die Wärmebehandlung im Schritt e) stattfindet, bei einer Bildung einer Schicht aus thermischem Oxid (318), die die Flanken des Emitterfensters (314) bedeckt.

4. Verfahren nach Anspruch 1, bei dem der Schritt a) außerdem die Bildung einer zweiten Vignettenschicht (303b) umfasst, die die erste Vignettenschicht (303a) überdeckt, wobei die zweite Vignettenschicht (303b) ein dotiertes Polysilicium ist, das einen Speicher Dotierverunreinigungen für die Bildung des Verbindungsbasisbereichs (323) bildet.

5. Verfahren nach Anspruch 4, bei dem die erste Vignettenschicht (303a) eine Schicht aus Siliciumdioxid (SiO₂) ist, und bei dem die zweite Vignettenschicht (303b), aus polykristallinem Silicium, mit Borfluorid (BF₂) dotiert ist.

6. Bipolarer Transistor mit, an der Oberfläche eines Siliciumsubstrats (300), einer sogenannten extrinsischen Basis (324), unter einer ersten Schicht (306) aus dotiertem polykristallinem Silicium, einer sogenannten intrinsischen Basis (322), getrennt von der extrinsischen Basis (324) und unter einer den Emitter bildenden zweiten Schicht (316) aus polykristallinem Silicium und isoliert von der ersten Schicht (306) aus polykristallinem Sllicium, und eine dritte sogenannte Verbindungsbasis (323), die die extrinsische Basis (324) und die intrinsische Basis (322) verbindet, wobei die Verbindungsbasis (323) sich im Wesentlichen unter der ersten Schicht (306) aus dotiertem polykristallinem Silicium befindet, **dadurch gekennzeichnet, dass** der Transistor außerdem eine Schicht aus nichtdotiertem thermischem Siliciumdioxid (303a) umfasst, die die Verbindungsbasis (323) von der ersten Schicht aus polykristallinem Silicium (306) trennt, wobei die Oxidschicht ausreichend dick ist, um eine Ätzsperrschicht zu bilden, und ausreichend dünn, um eine thermische Diffusion von Verunreinigungen durch diese Schicht hindurch zu ermöglichen.

7. Transistor nach Anspruch 6, der außerdem eine zusätzliche Schicht (303b) aus dotiertem polykristallinem Silicium umfasst, die auf der Siliciumdioxidschicht (303a) angeordnet ist und die Verbindungsbasis (323) von der ersten Schicht aus polykristallinen Silicium (306) trennt.

8. Transistor nach Anspruch 7, bei dem die zusätzliche Schicht (303b) aus polykristallinem Silicium und die erste Schicht (306) aus polykristallinem Silicium unterschiedliche Dotierungskonzentrationen aufweisen.
